# EUROPÄISCHE PATENTANMELDUNG

(11) **EP 2 975 768 A1**
(43) Veröffentlichungstag der Anmeldung: **20.01.2016**
(21) Anmeldenummer: 14177652.6
(22) Anmeldetag: 18.07.2014
(51) Int. Cl.: H03K 17/94, G06F 3/03, H03K 17/96

(54) **Bedieneinrichtung für Kraftfahrzeuge**

(71) Anmelder: SMR Patents S.à.r.l., 1653 Luxembourg (LU)
(72) Erfinder: Wieczorek, Romeo, 73732 Esslingen (DE)
(74) Vertreter: Weber-Bruls, Dorothée

(57) **Zusammenfassung**

Die vorliegende Erfindung betrifft eine Bedieneinrichtung (2, 2') für ein Kraftfahrzeug mit zumindest einem ToF-Sensor (28) zum Aussenden von Sendesignalen, Empfangen von Empfangssignalen und Abgeben von Informationssignalen, zumindest einem Lichtleiter (20, 20') zum Führen der Sendesignale von dem ToF-Sensor (28) zu zumindest einer Umlenkstelle (24', 24") zum Führen der an der Umlenkstelle (24', 24") umgelenkten Sendesignale zu einer zugeordneten, als Bedienelement fungierenden Austrittsstelle (26a - 26d, 26', 26") auf einer als Bedienfläche (22, 22') fungierenden ersten Fläche des Lichtleiters (20, 20') und bei Näherung eines Gegenstands, insbesondere in Form eines Fingers eines Anwenders, an die Austrittsstelle (26a - 26d, 26', 26") oder Berühren derselben zum Führen der an dem Gegenstand umgelenkten, insbesondere reflektierten, Sendesignale als Empfangssignale von der Austrittsstelle (26a - 26d, 26', 26") zu dem ToF-Sensor (28), und eine Kontrolleinheit, die in Abhängigkeit von den Empfangssignalen von dem ToF-Sensor (28) ausgegebenen Informationssignalen die der Austrittsstelle (26a - 26d, 26', 26") zugeordnete Funktion auslöst, und einen Innenspiegel sowie einen Außenspiegel mit solch einer Bedieneinrichtung.

## Beschreibung

Die vorliegende Erfindung betrifft eine Bedieneinrichtung für Kraftfahrzeuge und einen Innenspiegel sowie Außenspiegel eines Kraftfahrzeugs mit solch einer Bedieneinrichtung.

Optoelektronische Sensoren sind gut bekannt, auch solche, die ein Erfassen einer Lichtlaufzeit (ToF=Time of Flight) zur Distanzmessung nutzen und entweder als ToF-Sensoren oder PMD-Sensoren (Photonic Mixing Device Sensoren) bezeichnet werden. Einsatz finden die ToF-Sensoren insbesondere in Kameras. Die ToF-Kameras sind 3D-Kamerasysteme, die, wenn eine Szene mittels Sendersignale in Form von Lichtpulsen ausgeleuchtet wird, für jeden Bildpunkt die Zeit, die das Licht bis zu einem Objekt und wieder zurück braucht, misst. Die benötigte Zeit ist direkt proportional zur Distanz. Die Kamera liefert somit für jeden Bildpunkt die Entfernung des jeweils aufgenommenen Objektes. Ein besonderer Vorteil der ToF-Kamera liegt darin, dass eine effiziente Unterdrückung von Fremdlicht (z. B. Sonneneinstrahlung) erreicht wird, da aktive Sendersignale aus Umgebungslicht herausgefiltert werden können.

Aus der DE 20 2012 102 729 U1 ist ein optoelektronischer Sensor zur Erfassung von Objekten in einem Überwachungsbereich bekannt. Der Sensor umfasst einen Lichtsender zum Aussenden von Sendelicht, einen Lichtempfänger zum Erzeugen eines Empfangssignals aus von den Objekten in dem Überwachungsbereich reflektiertem Sendelicht, eine Auswertungseinheit zur Bestimmung von Informationen über die Objekte in dem Überwachungsbereich anhand des Empfangssignals sowie ein optisches Element mit einer ersten Grenzfläche und einer zweiten Grenzfläche, welches im Strahlengang des Sendelichts oder des reflektierten Sendelichts derart angeordnet ist, dass zumindest ein Teil des Sendelichts als Detektionslicht in den Überwachungsbereich gelangt.

ToF-Sensoren lassen sich auch zur Gestensteuerung z.B. in schwenkbaren Innenspiegeln für Kraftfahrzeuge nutzen, wie in der nicht vorveröffentlichten EP 14163459 beschrieben. Nachteilig daran ist jedoch, dass die Gesten sowohl im Kraftfahrzeug hinterlegt als auch dem Anwender bekannt sein müssen.

Üblich ist in Kraftfahrzeugen der Einsatz von Touchscreens, die jedoch nachteiliger Weise aufwändige Technologien, wie kapazitive Flächen, zur Funktionsauslösung benötigen.

Aufgabe der vorliegenden Erfindung ist es daher, eine Bedieneinrichtung für Kraftfahrzeuge zu liefern, die die Nachteile des Stands der Technik überwindet.

Diese Aufgabe wird erfindungsgemäß gelöst durch eine Bedieneinrichtung für ein Kraftfahrzeug mit zumindest einem ToF-Sensor zum Aussenden von Sendesignalen, Empfangen von Empfangssignalen und Abgeben von Informationssignalen, zumindest einem Lichtleiter zum Führen der Sendesignale von dem ToF-Sensor zu zumindest einer Umlenkstelle, zum Führen der an der Umlenkstelle umgelenkten Sendesignale zu einer zugeordneten, als Bedienelement fungierenden Austrittsstelle auf einer als Bedienfläche fungierenden ersten Fläche des Lichtleiters und bei Näherung eines Gegenstands, insbesondere in Form eines Fingers eines Anwenders, an die Austrittsstelle oder Berühren derselben zum Führen der an dem Gegenstand umgelenkten, insbesondere reflektierten, Sendesignale als Empfangssignale von der Austrittsstelle zu dem ToF-Sensor, und eine Kontrolleinheit, die in Abhängigkeit von den Empfangssignalen von dem ToF-Sensor ausgegebenen Informationssignalen die der Austrittsstelle zugeordnete Funktion auslöst.

Dabei kann vorgesehen sein, dass die Umlenkstelle auf einer der ersten Fläche des Lichtleiters gegenüberliegenden Fläche des Lichtleiters bereitgestellt ist, und/oder eine Einkoppelfläche des Lichtleiters für die Sendesignale zur ersten und/oder zweiten Fläche geneigt ist, vorzugsweise um ca. 90 Grad.

Erfindungsgemäß bevorzugt ist, dass die Umlenkstelle zumindest eine Ausnehmung, insbesondere in Form einer Frässtelle, umfasst, wobei vorzugsweise über die Kontur der Ausnehmung und/oder eine Beschichtung derselben Anzahl, Ort und/oder Bemaßung der zugeordneten Austrittsstelle(n) und/oder Intensität des umgelenkten Sendesignals bestimmt ist bzw. sind.

Weiterhin wird erfindungsgemäß vorgeschlagen, dass eine Vielzahl von Umlenkstelle und/oder Austrittsstellen bereitgestellt ist bzw. sind, und/oder jede Austrittsstelle eine Taste oder einen Teil eines Schiebereglers darbietet.

Erfindungsgemäße Bedieneinrichtungen sind ferner gekennzeichnet durch zumindest eine Markierung im Bereich der Austrittsstelle(n), insbesondere in Form einer Beschichtung, Oberflächenbearbeitung und/oder Beleuchtung des Lichtleiters.

Zudem können erfindungsgemäße Bedieneinrichtungen gekennzeichnet sein durch eine Befestigungseinrichtung zur Anbringung in dem Kraftfahrzeug, insbesondere an oder in einem Innenspiegel, einem Außenspiegel, einer Armaturenblende oder einer Tür.

Mit der Erfindung wird auch vorgeschlagen, dass der Lichtleiter Teil eines Beleuchtungsmoduls des Kraftfahrzeugs, insbesondere eines Blinkermoduls in einem Außenspiegel, ist.

Zudem kann vorgesehen sein, dass die Kontrolleinheit eine Zugangsberechtigung durch Auswertung der Informationssignale prüft, insbesondere durch Erfassen biometrischer Informationen und/oder eines Bediencodes, wie in Form einer Reihenfolge und/oder Länge der Berührung von Austrittsflächen einer Vielzahl von Austrittsflächen.

Weiterhin wird vorgeschlagen, dass die Sende- und Empfangssignale im Bereich vom Infrarot- oder sichtbarem Licht liegen.

Auch kann vorgesehen sein, dass der ToF-Sensor eine Auswerteeinrichtung umfasst, über die eine für das Material des Lichtleiters charakteristische Größe, insbesondere der Berechnungsindex des Materials des Lichtleiters, berücksichtbar, einstellbar oder veränderbar ist.

Die Erfindung liefert auch einen Innenspiegel eines Kraftfahrzeuges mit einer erfindungsgemäßen Bedieneinrichtung. Dabei kann vorgesehen sein, dass die Bedienfläche in einem Rahmen eines Spiegelelements und/oder benachbart zu dem Spiegelelement oder in einem Beleuchtungsmodul des Innenspiegels angeordnet ist.

Schließlich liefert die Erfindung auch einen Außenspiegel eines Kraftfahrzeuges mit einer erfindungsgemäßen Bedieneinrichtung. Dabei kann vorgesehen sein, dass die Bedienfläche in einem Rahmen eines Spiegelelements und/oder benachbart zu dem Spiegelelement oder in einem Beleuchtungsmodul des Außenspiegels, insbesondere in Form eines Blinkermoduls, angeordnet ist.

Der Erfindung liegt somit die überraschende Erkenntnis zugrunde, die Vorteile eines ToF-Sensors mit seiner Fähigkeit zur genauen Distanzmessung und die Vorteile eines Lichtleiters mit der Einfachheit seiner Herstellung und/oder Bearbeitung zur Bereitstellung definierter Umlenkstellen und Austrittsstellen für Licht, über die Berührungspositionen definiert werden können, die gezielt Funktionen in einem Fahrzeug zugeordnet werden können, zu kombinieren. Durch Annäherung bspw. eines Fingers eines Fahrers eines Fahrzeuges an solch einer Austrittsstelle für Licht kommt es nämlich zur Reflexion von in dem Lichtleiter geführtem Licht von dem ToF-Sensor, das über den Lichtleiter dem ToF-Sensor wieder zuführbar ist, um eine Funktion wie ein Blinken, Dimmen eines Spiegels, Einschalten einer Warnleuchte, Einstellen einer Klimaanlage oder dergleichen auszulösen. Mit anderen Worten wird durch die Kombination eines ToF-Sensors mit einem Lichtleiter, ggf. auch einer Vielzahl von ToF-Sensoren mit einem oder mehreren Lichtleitern oder eines ToF-Sensors mit mehreren Lichtleitern, eine Art Touchscreen zur Verfügung gestellt wird, das ohne kapazitive Flächen und dergleichen auskommt. Es kann selbst ein Lichtleiter zum Einsatz kommen, der bereits im Fahrzeug eine Funktion erfüllt, wie ein Lichtleiter in einem Blinkermodul.

Weitere Merkmale und Vorteile der Erfindung ergeben sich aus der nachfolgenden Beschreibung eines Ausführungsbeispiels anhand schematischer Zeichnungen. Dabei zeigt:
- Figur 1: eine Draufsicht auf einen Teil eines erfindungsgemäßen Innenspiegels; und
- Figur 2: eine Teilschnittansicht durch eine erfindungsgemäße Bedieneinrichtung.

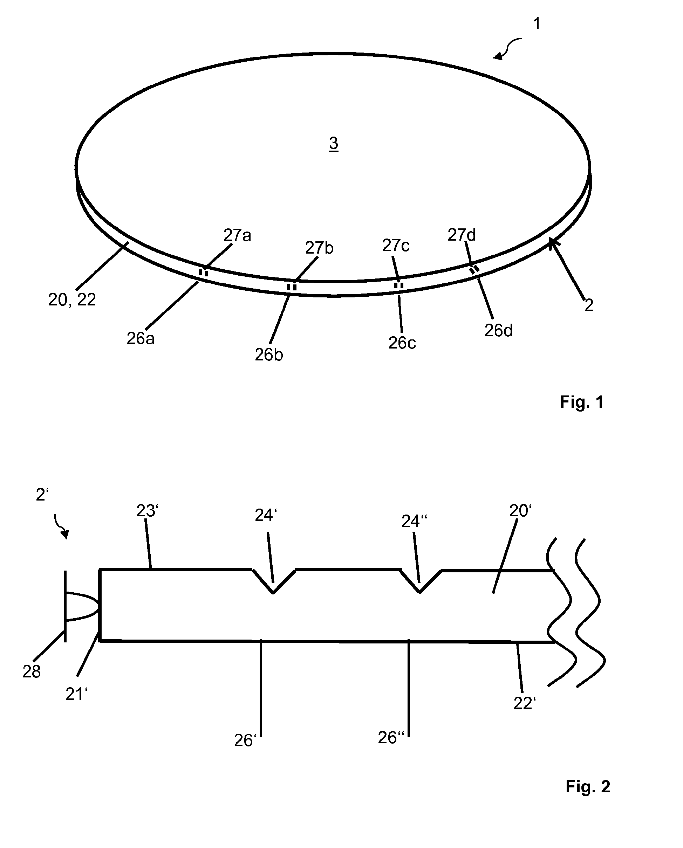

Figur 1 zeigt einen erfindungsgemäßen Innenspiegel 1 eines Fahrzeuges (nicht gezeigt) mit einer Bedieneinrichtung 2 und einem Spiegelelement 3. Die Bedieneinrichtung 2 ist unterhalb des Spiegelelements 3 in einem nicht gezeigten Rahmen desselben angeordnet und bietet eine Bedienfläche 22 dar. Auf der Bedienfläche 22 sind vier Tasten zum Auslösen von Funktionen innerhalb des Fahrzeuges, in dem der Innenspiegel 1 montiert ist, betätigbar, wobei jede Taste gebildet wird durch eine Lichtaustrittsstelle 26a - 26d, und zur Erleichterung der Erkennbarkeit der Taste im Bereich jeder Lichtaustrittsstelle 26a - 26d eine Markierung 27a - 27d bspw. in Form einer Beschichtung eines die Bedienfläche 22 bereitstellenden Lichtleiters 20 zugeordnet ist.

Mit Bezug auf Figur 2 wird nun die Bedieneinrichtung 2 näher erläutert. Genauer gesagt zeigt Figur 2 eine Bedieneinrichtung 2' mit einem Lichtleiter 20', der eine Lichteinkoppelfläche 21', eine Bedienfläche 22' und eine Lichtumlenkfläche 23' aufweist. Licht eines ToF-Sensors 28 kann in den Lichtleiter 20' über die Lichteinkoppelfläche 21' eingekoppelt werden, um sich im Lichtleiter 20' auszubreiten. Ein Teil des Lichtes wird an Lichtumlenkstellen 24', 24" auf der Lichtumlenkfläche 23' umgelenkt, und zwar in Richtung von Lichtaustrittsstelle 26', 26" auf der Bedienfläche 22'. Dabei sind die Bedienfläche 22' und Lichtumlenkfläche 23' im wesentlichen parallel zueinander und senkrecht zur Lichteinkoppelfläche 21', wobei diese Relativanordnung nicht zwingend ist.

Jeder Lichtumlenkstelle 24', 24" ist eine Lichtaustrittsstelle 26', 26" zugeordnet. Es ist aber auch möglich, nämlich durch Variation der Kontur der Lichtumlenkstelle 24', 24", denselben mehrere Lichtaustrittsstellen zuzuordnen. Jede Lichtumlenkstelle kann durch ein Ausfräsen hergestellt werden, bspw. derart, dass die dazugehörige Lichtaustrittsstelle eine definierten Tastenpunkt bereitstellt. Um an den Lichtaustrittsstellen 26', 26" gleiche Lichtintensität zu erhalten, ist die zweite Lichtumlenkstelle 24" tiefer in den Lichtleiter 20' einzubringen als die erste Lichtumlenkstelle 24'. Die Ausfräsung kann aber auch derart sein, dass eine Vielzahl von Frässtellen sehr nah aneinander und nicht sehr tief bereitgestellt werden, so dass über eine entsprechende Vielzahl von Lichtaustrittsstellen ein Schieberegler auf der Bedienfläche 22' bereitgestellt wird. Tatsächlich lassen sich durch gezieltes Ausfräsen des Lichtleiters 20' einfach eine Vielzahl von unterschiedlichen Lichtaustrittsstellen erzeugen.

Nähert sich ein Finger (nicht gezeigt) eines Fahrers des Fahrzeugs, in dem die Bedieneinrichtung 2' bspw. benachbart zu einem Spiegelelement gemäß Figur 1 eingebaut ist, der Lichtaustrittsstelle 26', so wird Sendelicht vom ToF-Sensor 28, das an der Lichtumlenkstelle 24' in Richtung der Lichtaustrittsstelle 26' umgelenkt worden ist, an dem Finger reflektiert, um über den Lichtleiter 20' als Empfangslicht zurück zu dem ToF-Sensor 28 zu gelangen und dort ausgewertet zu werden. Der ToF-Sensor 28 umfasst dazu in bekannter Weise eine Auswerteeinrichtung, die an das jeweilige Material des Lichtleiters 20' angepasst ist und bei Erkennen der Berührung der Lichtaustrittsstelle 26' ein entsprechendes Informationssignal an eine nicht gezeigte Kontrolleinheit des Fahrzeugs weiterleitet, um eine der Lichtaustrittsstelle 26' zugeordnete Funktion auszulösen, bspw. ein Blinken nach links, während bei Berührung der Lichtaustrittsstelle 26" ein Blinken nach rechts auslösbar sein kann.

Um die Lichtaustrittsstellen 26', 26" besser erkennen zu können, kann der Lichtleiter 20' in den entsprechenden Bereichen poliert sein. Auch ist es möglich, dass der ToF-Sensor 28 sichtbares Licht aussendet, so dass die Lichtaustrittsstellen 26', 26" hell aufscheinen. Zudem kann im Bereich der Lichtaustrittsstellen 26', 26" eine Beschichtung des Lichtleiters 20' (nicht gezeigt) bereitgestellt sein, bspw. in Form der Buchstaben "L" und "R", um dem Fahrer die Bedienung zu erleichtern, indem beim Berühren der Lichtaustrittsstelle 26' mit der Markierung "L" der linke Blinker und bei Berührung der Lichtaustrittsstelle 26" mit der Markierung "R" der rechte Blinker ausgelöst wird.

Selbstverständlich kann der ToF-Sensor 28 auch im IR-Bereich arbeiten. Dann könnte(n) zusätzlich eine oder mehrere LEDs zur Markierung der Lichtaustrittsstellen 26', 26" auf der Seite der Lichteinkoppelfläche 21' angeordnet sein.

Mit der erfindungsgemäßen Bedieneinrichtung 2, 2' ist es möglich, auf einfache Weise ein Touchscreen darzustellen, das selbst Lichtleiter, die bereits in einem Fahrzeug vorhanden sind, nutzt. So kann der Lichtleiter eines Blinkers als Lichtleiter einer erfindungsgemäßen Bedieneinrichtung verwendet werden, bspw. um durch Berührung an einer bestimmten Lichtaustrittsstelle das Fahrzeug zu verriegeln oder zu öffnen. Um einen Missbrauch zu vermeiden, kann vor Öffnung bzw. Verriegelung des Fahrzeuges noch eine Bedienungsberechtigung überprüft werden. Aufgrund der Messgenauigkeit eines ToF-Sensors ist es bspw. möglich, einen Fingerabdruck auszuwerten, um so nur einen Berechtigten eine Funktion in einem Fahrzeug auslösen zu lassen. Anstelle der Auswertung eines Fingerabdruckes oder einer sonstigen biometrischen Erkennung kann aber auch ein Bediencode hinterlegt sein, wie in Form der Reihenfolge der Berührung unterschiedlicher Lichtaustrittsstellen, um eine Authentifizierung durchzuführen.

Die in der voranstehenden Beschreibung, den Ansprüchen sowie den Zeichnungen offenbarten Merkmale können sowohl einzeln als auch in jeder beliebigen Kombination für die Verwirklichung der Erfindung in ihren verschiedenen Ausführungsformen wesentlich sein.

### Bezugszeichenliste

- 1: Innenspiegel
- 2, 2': Bedieneinrichtung
- 3: Spiegelelement
- 20, 20': Lichtleiter
- 21': Lichteinkoppelfläche
- 22, 22': Bedienfläche
- 23': Lichtumlenkfläche
- 24', 24": Lichtumlenkstelle
- 26', 26", 26a-26d: Lichtaustrittsstelle
- 27a - 27d: Markierung
- 28: ToF-Sensor

## Patentansprüche

1. Bedieneinrichtung (2, 2') für ein Kraftfahrzeug mit
zumindest einem ToF-Sensor (28) zum Aussenden von Sendesignalen, Empfangen von Empfangssignalen und Abgeben von Informationssignalen,
zumindest einem Lichtleiter (20, 20') zum Führen der Sendesignale von dem ToF-Sensor (28) zu zumindest einer Umlenkstelle (24', 24"), zum Führen der an der Umlenkstelle (24', 24") umgelenkten Sendesignale zu einer zugeordneten, als Bedienelement fungierenden Austrittsstelle (26a - 26d, 26', 26") auf einer als Bedienfläche (22, 22') fungierenden ersten Fläche des Lichtleiters (20) und bei Näherung eines Gegenstands, insbesondere in Form eines Fingers eines Anwenders, an die Austrittsstelle (26a - 26d, 26', 26") oder Berühren derselben zum Führen der an dem Gegenstand umgelenkten, insbesondere reflektierten, Sendesignale als Empfangssignale von der Austrittsstelle (26a - 26d, 26', 26") zu dem ToF-Sensor (28), und
eine Kontrolleinheit, die in Abhängigkeit von den Empfangssignalen von dem ToF-Sensor (28) ausgegebenen Informationssignalen die der Austrittsstelle (26a - 26d, 26', 26") zugeordnete Funktion auslöst.

2. Bedieneinrichtung nach Anspruch 1, **dadurch gekennzeichnet, dass**
die Umlenkstelle (24', 24") auf einer der ersten Fläche (22') des Lichtleiters (20') gegenüberliegenden Fläche (23') des Lichtleiters (20') bereitgestellt ist, und/oder
eine Einkoppelfläche (21') des Lichtleiters (20') für die Sendesignale zur ersten und/oder zweiten Fläche (22', 23') geneigt ist, vorzugsweise um ca. 90 Grad.

3. Bedieneinrichtung nach Anspruch 1 oder 2, **dadurch gekennzeichnet, dass**
die Umlenkstelle (24', 24") zumindest eine Ausnehmung, insbesondere in Form einer Frässtelle, umfasst, wobei vorzugsweise über die Kontur der Ausnehmung und/oder eine Beschichtung derselben Anzahl, Ort und/oder Bemaßung der zugeordneten Austrittsstelle(n) (26', 26") und/oder Intensität des umgelenkten Sendesignals bestimmt ist bzw. sind.

4. Bedieneinrichtung nach einem der vorangehenden Ansprüchen, **dadurch gekennzeichnet, dass**
eine Vielzahl von Umlenkstelle (24', 24") und/oder Austrittsstellen (26a - 26d, 26', 26") bereitgestellt ist bzw. sind, und/oder
jede Austrittsstelle (26a - 26d, 26', 26") eine Taste oder einen Teil eines Schiebereglers darbietet.

5. Bedieneinrichtung nach einem der vorangehenden Ansprüche, **gekennzeichnet durch**
zumindest eine Markierung (27a - 27d) im Bereich der Austrittsstelle(n) (26a-26d), insbesondere in Form einer Beschichtung, Oberflächenbearbeitung und/oder Beleuchtung des Lichtleiters.

6. Bedieneinrichtung nach einem der vorangehenden Ansprüche, **gekennzeichnet durch**
eine Befestigungseinrichtung zur Anbringung in dem Kraftfahrzeug, insbesondere an oder in einem Innenspiegel, einem Außenspiegel, einer Armaturenblende oder einer Tür.

7. Bedieneinrichtung nach einem der vorangehenden Ansprüchen, **dadurch gekennzeichnet, dass**
der Lichtleiter Teil eines Beleuchtungsmoduls des Kraftfahrzeugs, insbesondere eines Blinkermoduls in einem Außenspiegel, ist.

8. Bedieneinrichtung nach einem der vorangehenden Ansprüchen, **dadurch gekennzeichnet, dass**
die Kontrolleinheit eine Zugangsberechtigung durch Auswertung der Informationssignale prüft, insbesondere durch Erfassen biometrischer Informationen und/oder eines Bediencodes, wie in Form einer Reihenfolge und/oder Länge der Berührung von Austrittsflächen einer Vielzahl von Austrittsflächen.

9. Bedieneinrichtung nach einem der vorangehenden Ansprüchen, **dadurch gekennzeichnet, dass**
die Sende- und Empfangssignale im Bereich vom Infrarot- oder sichtbarem Licht liegen.

10. Bedieneinrichtung nach einem der vorangehenden Ansprüche, **dadurch gekennzeichnet, dass**
der ToF-Sensor (28) eine Auswerteeinrichtung umfasst, über die eine für das Material des Lichtleiters charakteristische Größe, insbesondere der Berechnungsindex des Materials des Lichtleiters (20, 20'), berücksichtbar, einstellbar oder veränderbar ist.

11. Innenspiegel (1) eines Kraftfahrzeuges mit einer Bedieneinrichtung (2) nach einem der vorangehenden Ansprüche.

12. Innenspiegel nach Anspruch 11, **dadurch gekennzeichnet, dass**
die Bedienfläche (22) in einem Rahmen eines Spiegelelements (3) und/oder benachbart zu dem Spiegelelement (3) oder in einem Beleuchtungsmodul des Innenspiegels (1) angeordnet ist.

13. Außenspiegel eines Kraftfahrzeuges mit einer Bedieneinrichtung nach einem der Ansprüche 1 bis 10.

14. Außenspiegel nach Anspruch 13, **dadurch gekennzeichnet, dass**
die Bedienfläche in einem Rahmen eines Spiegelelements und/oder benachbart zu dem Spiegelelement oder in einem Beleuchtungsmodul des Außenspiegels, insbesondere in Form eines Blinkermoduls, angeordnet ist.
